# EUROPEAN PATENT SPECIFICATION

(11) **EP 0 584 728 B1**
(45) Date of publication and mention of the grant of the patent: **29.10.1997**
(21) Application number: 93113298.9
(22) Date of filing: 19.08.1993
(51) Int. Cl.: H05K 5/02, H05K 9/00, H05K 7/14, G06K 19/077

(54) **Grounded memory card holder**
Geerdeter Speicherkartenhalter
Support pour carte à mémoire mise à la terre

(30) Priority: 21.08.1992 US 933265; 21.08.1992 US 933321
(43) Date of publication of application: 02.03.1994
(73) Proprietor: THE WHITAKER CORPORATION, Wilmington, Delaware 19808 (US)
(72) Inventor: Marsh, Edward K., Kernersville, North Carolina 27284 (US); Barker, Riley Keith, Lexington, North Carolina 27292 (US)
(74) Representative: Klunker . Schmitt-Nilson . Hirsch

(56) References cited:
- EP-A- 0 040 753
- EP-A- 0 439 122
- WO-A-91/10345
- US-A- 4 872 091
- PATENT ABSTRACTS OF JAPAN vol. 13, no. 135 (P-851) 5 April 1989 & JP-A-63 302 490 (MITSUBISHI) 9 December 1988

## Description

This invention relates to a memory card holder according to the preamble of claim 1.

This invention relates generally to memory cards for use with computer and computer-type equipment. Specifically, the invention relates to memory card holders which include an electrical connector and a frame for receiving a memory card containing electrical circuit traces and ground traces thereon, the frame including a pair of side rails, and a pair of hermaphroditic, electrically conductive cover members adapted to engage the side rails.

With the advent of sophisticated computers, facsimile machines, printers, and other computer-related and electronic equipment, the need for more memory to store important data for use by the computer and computer-related equipment is ever increasing. To this end, memory cards containing external memory and data to be used in computer processes have been designed. Examples of such memory cards are shown in U.S. Patent No. 5,005,106 - Kiku, and U.S. Patent No. 4,872,099 - Miniwa et al.. These memory cards are useful for printers, copiers, word processors, telefax machines, and other electronic equipment which require an external memory.

As shown in the Kiku and Miniwa et al. patents, as well as in other patents in the art, a memory card or cartridge generally comprises a printed circuit board, a housing made of an insulating material for housing the printed circuit board, and at least one connector on one end of the card which accommodates the printed circuit board and which interfaces with a computer or other electronic device. The connector is generally denoted an "input/output" or "I/O" connector and interfaces with the printed circuit board in the card to access the contents of memory stored therein, and to bus data to and from an outside environment which usually comprises another computer or other electronic equipment. In this fashion, data traverses the interface between the memory card and the outside environment so that the data can be efficiently transferred and used for its intended purpose by the computer in which the memory card is mated. Memory cards of this nature are generally interchangeable and can be used with different machines and electronic components in a laboratory, office, or other installation.

Since memory cards are used in conjunction with computers and electronic equipment, high speed data transfer often occurs across the connector interfaces. The electrical signals comprising the data transfer are usually digital in nature, and so are subject to error when extraneous electrical signals are routed to the memory card or otherwise impinge on the printed circuit board found therein. When such electrical interference occurs, erroneous information is bussed between the outside environment and the memory card such that the electronic devices which utilize the information do not perform properly due to the processing of erroneous data. Additionally, the memory card itself experiences data error in this situation so that the data stored therein becomes prone to degradation.

In order to prevent these problems, attempts have been made in the art to ensure that the memory card is grounded to the external computer or electronic device in which it is mated. A ground of this nature, generally denoted a "chassis ground," ensures that the memory card will not "float." Floating of an electronic component, such as a memory card, occurs when the electronic component does not see an adequate ground to close a circuit comprising the component. Floating of electronic equipment is generally undesirable and thus should be avoided.

Additionally, the printed circuit board found in the memory card is also sometimes not adequately grounded to the card, in which case the printed circuit board itself floats with respect to the memory card, thereby producing undesirable data signal characteristics. In order to avoid this problem, prior memory cards which contain printed circuit boards have been provided with spring contact clips in attempts to ground the circuit board to the memory card and ultimately to the final ground which the memory card sees after it has been mated to the computer or other electronic component.

Various arrangements have been devised to better facilitate grounding of printed circuit boards to the memory cards to avoid the aforementioned problems. One such arrangement provides removable clips which have been fastened around the frame in the memory card to hold the circuit board to the frame and provide grounding. However, these clips are easily detached from the frame and do not provide sufficient mechanical or electrical coupling of the printed circuit board to the frame in the memory card to ensure adequate grounding. The resultant poor grounding of the printed circuit board to the memory card and the degraded signal characteristics it produces are undesirable.

Accordingly, applicants have recognized that memory cards having printed circuit boards for use in computers and other electronic equipment should be provided with efficient and reliable means for grounding the circuit board to the memory card. Applicants have also recognized that it is further desirable to achieve hard chassis grounding of memory cards to external electronic equipment in which the memory cards are mated. Such results have not heretofore been achieved in the art.

Memory cards are generally interchangeable and can be used with many different machines and electronic components. Because the memory cards are interchangeable, they undergo a significant amount of abuse when transported, interfaced and mated to the different computers and electronic equipment which use them. Since a memory card is conventionally made up of a number of layers and/or elements glued or otherwise bonded together, the individual layers tend to become loose and/or separated from one another as the memory card is subject to flexing stress, as typically occurs when the card is inserted into or removed from the electronic or other computer-type equipment. Thus, even after moderate amounts of usage, conventional memory cards have heretofore frequently become structurally loose, and the internal members of the card often become misaligned. This results in failure of the memory card and degrades the performance of the electronic equipment which uses the card. These undesirable results generally induce poor performance of the computer system which uses the memory card.

The aforementioned disadvantages of the prior art are overcome, by a memory card holder in accordance with the present invention defined in claim 1.

Grounding circuit elements in a memory card preferably comprises the steps of mounting the memory card to a frame in the memory card holder sealing the memory card holder by mounting the cover to the frame wherein the cover comprises a substantially conductive material, and grounding the memory card to the memory card holder through a grounding tab formed on the cover such that when the cover seals the memory card in the memory card holder, the grounding tab is interfaced to the memory card.

The invention provides efficient grounding of traces to memory card holders so that the memory cards do not float in the memory card holders. Since a hard chassis ground is thus achieved for the memory cards through the device in which the memory card holder is mated, data communication and signal transfer between the memory card and an outside environment are greatly enhanced. Therefore, the possibility of data error and other electrical transmission problems are concomitantly reduced, and a high reliability data link is achieved. Thus memory card holders provided in accordance with the present invention are capable of effectively providing high speed data transfer and communications with little to no data error.

Furthermore, embodiments of the invention achieve good grounding of circuit elements to memory card holders without the addition of complex hardware to the memory card holders. This allows memory card holders provided in accordance with the present invention to be economically and efficiently fabricated and to be readily interfaced with existing computers and other electronic equipment. These results have not heretofore been achieved in the art and evince significant advantages over prior memory cards.

The memory card holder comprises connector means for interfacing data between the circuit element and an outside environment which will utilize the memory card, said connector means comprising mating means for mechanically interfacing said connector means to the frame. The memory card holder also comprises mating means on the frame for mechanically interfacing with said connector mating means such that said connector means provides structural integrity to the memory card when the frame and connector are mated. According to preferred embodiments of the present invention, the connector mating means comprises interlocking means, such as tabs, and the frame mating means comprises receiving means for snugly receiving the tabs and locking the connector means to the frame.

For imparting improved structural integrity to a memory card. There are provided the steps of mating a circuit element to a partially rigid frame to form a partial memory card, interfacing a connector to the circuit element to provide an interface to the partial memory card, and mechanically interfacing mating means on the connector to mating means on the frame so as to provide rigidity to the frame and to give the memory card structural integrity.

By mechanically interfacing a connector mating means, such as a tab, with a frame mating means, such as a socket or pocket on the frame adapted to receive the tab, the memory card is provided with structural integrity. Furthermore, such memory cards are adaptable for use with many different computer and computer-type components without degradation or misalignment of the internal components of the card. This further ensures flexible and economic operation of electronic devices utilizing memory cards in accordance with the present invention. Furthermore, since memory card holders described and claimed herein resist structural loosening upon mating and demating with electronic equipment, it is possible for the user of the memory cards to purchase fewer of these cards and to use the cards in a number of different devices in an office, laboratory, or other installation where the cards and computer devices are operated. This provides great equipment cost savings and economy.

Specifically, a memory card holder is provided which includes an electrical connector and a frame for receiving a memory card containing electrical circuit traces and ground traces thereon, said frame including a pair of side rails, and a pair of hermaphroditic, electrically conductive cover members adapted to engage said side rails, characterized in that each said cover member includes an integral angularly disposed, inwardly directed grounding tab for compressive contact with a complementary ground trace on said memory card, and plural peripheral tabs in contact with and in sealing engagement with said frame side rails; and wherein interlocking members are provided on the connector and the frame for joining the connector to the frame and the memory card.

The invention will now be described with reference to the accompanying drawings in which:

Figure 1 is an isometric, exploded view of a memory card holder provided in accordance with one embodiment of the present invention.

Figures 2A, 2B and 2C are plan, elevational, and isometric views respectively of a top cover of a memory card holder having a grounding tab in accordance with one embodiment of the present invention.

Figures 3A, 3B and 3C are plan, elevational, and isometric views respectively of a bottom cover of a memory card holder having a grounding tab provided in accordance with one embodiment of the present invention.

Figure 4 is cross-sectional, end view of the bottom cover of the memory card holder of Figure 1 showing a grounding tab.

Figures 5A and 5B are plan and isometric views of a frame for mounting a printed circuit board in a memory card holder.

Figure 6A is an isometric view of an input/output connector provided in accordance with one embodiment of the present invention that is surface mounted to a printed circuit board for use in a memory card holder.

Figure 6B is a partial plan view of the frame portion of a memory card holder showing a jigsaw receptacle according to one embodiment of the present invention.

Figures 7A and 7B are plan and elevation views of an input/output connector showing jigsaw tabs provided in accordance with one embodiment of the present invention to provide structural integrity to a memory card.

Figure 8 is an isometric view of an input/output connector according to one embodiment of the present invention having a jigsaw tab mated in a reciprocal receiving jigsaw aperture in the frame of a memory card holder.

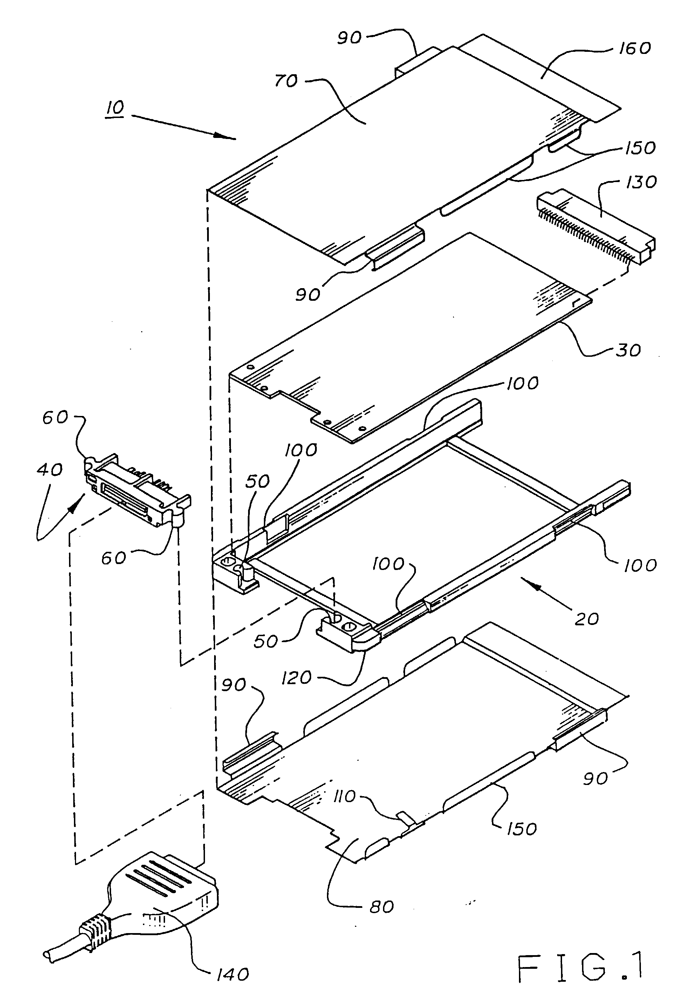

Referring now to the drawings wherein like reference numerals refer to like elements, Figure 1 is an exploded isometric view of a memory card holder shown generally at 10 having frame 20 for housing a memory card shown generally at 30, in the card holder. The memory card 30 could be for example, a printed circuit board, a printed wiring board or simply a semiconductor substrate. It will be recognized by those with skill in the art that any device requiring grounding in accordance with the present invention can be housed in memory card holder 10. For ease of description throughout, memory card 30 will also be referred to as a "printed circuit board," but this should not be construed as in any way limiting the invention.

In a preferred embodiment, memory card 10 comprises a connector shown generally at 40 which is adapted to mate with the printed circuit board 30 and to interface data to and from an outside environment, such as a computer or computer-related electronic device, through the memory card holder 10. The connector 40 is generally denoted an "input/output" connector, but similarly the present invention is not limited to input/output connectors.

In a further preferred embodiment, lateral receiving pockets 50 on frame 20 are adapted to mount the input/output connector 40 to the printed circuit board 30 and to lock the input/output connector 40 to frame 20. In still a further preferred embodiment, locking tabs 60 integrally formed on the input/output connector 40 are provided to mechanically mate with the lateral receiving pockets 50 and to securely lock the input/output connector 40 to frame 20. This arrangement aids in holding the printed circuit board 30 to the frame 20 and further holding the components of memory card holder 10 together.

The memory card holder 10 also preferably comprises a cover member in sealing engagement with the frame 20 for securing printed circuit board 30 in the frame. In a further preferred embodiment, the memory card holder comprises grounding means integrally attached to the cover member for grounding the printed circuit board 30 to the memory card holder 10.

In yet further preferred embodiments, the cover member comprises a top cover 70 and a bottom cover 80 which are attached to frame 20 to permanently seal circuit board 30 within memory card holder 10. Good sealing engagement of the top and bottom covers is achieved since frame 20 preferably comprises a unitary structure of a plurality of interconnected members which form a space or opening in which the printed circuit board 30 sits when mounted to frame 20. A pair of press-fit tabs 90 are attached to and preferably protrude from the side of top cover 70 and are adapted to mate with reciprocal press-fit openings 100 on the unitary frame 20. Similar press-fit tabs are attached to and protrude from bottom cover 80 to mate with other reciprocal press-fit openings found on frame 20. The press-fit tabs and openings interface together to close the memory card and encase the printed circuit board therein.

In accordance with the present invention, the grounding means 110 comprises a grounding tab which is integrally formed on bottom cover 80 and is adapted to ground the printed circuit board to unitary frame 20. The entire memory card holder 10 is then grounded to, for example, a computer, through contacts 120 which are attached to the unitary frame 20. In a preferred embodiment, contacts 120 are common spring contacts but it will be recognized by those with skill in the art that any type of grounding contact can be mounted to frame 20 to ground memory card holder 10 to the computer or other electronic device. In this fashion, the memory card holder is grounded to the chassis of the computer or other electronic device in which it is placed for operational purposes.

In still further preferred embodiments, a computer connector 130 is provided to the memory card holder 10 on the opposite side of the card from input/output connector 40 so that the card can be electrically interfaced for data transfer to a computer or other device which will utilize the card's memory. In general, computer connector 130 is of a two-piece design comprising a posted header for loading onto the host equipment such as a computer, and a receptacle assembly which is used by the memory card holder 10. Such a connector is described in AMP, Inc. (Harrisburg, Pa.) Product Specification 108-5287, entitled "Memory/PC Card Connector," dated 1991.

The operation of memory card holder 10 is generally known to those with skill in the art. Memory modules (not shown) are mounted on printed circuit board 30 and contain data to be used by the computer or other device to which memory card holder 10 is mated. Data communications between the printed circuit board 30 and the computer in which card holder 10 is mated occur through computer connector 130 when the system is in use. As mentioned above, in a preferred embodiment connector 40 is an input/output connector which is adapted to interface with printed circuit board 30 with an outside environment such as another computer or electronic device. Since memory card holder 10 will interface with an outside environment, plug receptacle 140 is also associated with the card 10. Plug receptacle 140 interfaces the outside environment with input/output connector 40 so that data can be transferred between the outside environment and memory card 10 through input/output connector 40. Thus, data is transferred in an efficient manner between memory card 10 and the outside environment through plug receptacle 140 and input/output connector 40, and further to a computer to which card 10 is mated through computer connector 130.

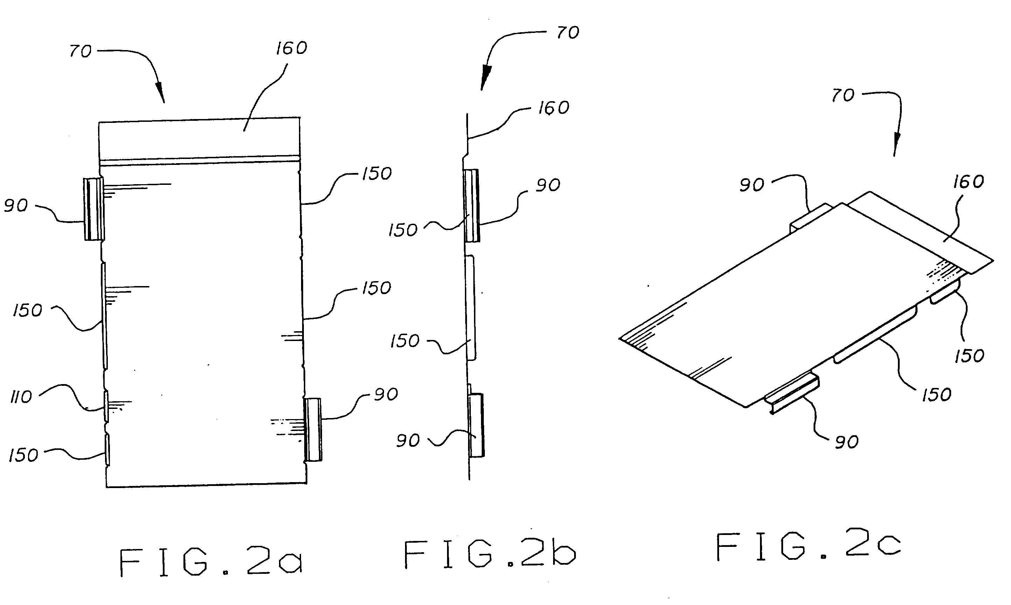

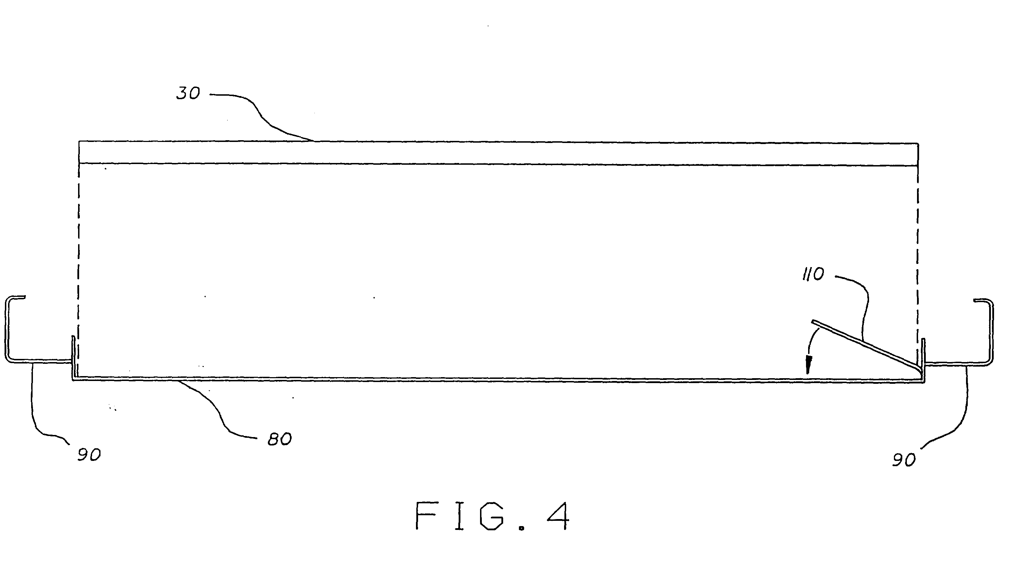

Referring to Figures 2A, 2B and 2C, the grounding arrangement provided to memory card holder 10 by top cover 70 in preferred embodiments is better illustrated. Top cover 70 preferably comprises a substantially conductive material which grounds memory card holder 10 to the electronic device in to which it is mated. A grounding tab 110 (also shown in Figure 4) is preferably integrally formed on cover 70 similar to the grounding tab 110 on bottom cover 80 and is also adapted to interface with the printed circuit board 30 when top cover 70 is in place on the memory card holder 10 to seal the printed circuit board in the memory card holder. In a further preferred embodiment, a plurality of side tabs 150 is also integrally formed from cover 70 and acts to align cover 70 on the memory card holder 10 to further promote efficient sealing of the printed circuit board 30 in the memory card holder.

When cover 70 is sealed to the printed circuit board 30, the grounding tab 110 preferably interfaces with the printed circuit board and grounds the printed circuit board 30 to the memory card. This grounding arrangement is accomplished since the press-fit protrusions 90 mate securely with the reciprocal openings 100 on the frame to tightly seal cover 70 to the frame so that the grounding tab 110 is substantially flattened or pinched against the printed circuit board 30, thereby making good grounding contact.

Top cover 70 also preferably comprises a computer connector receptacle 160 which is adapted to house computer connector 130 in the memory card 10. It is preferable to form top cover 70, press-fit protrusions 90, grounding tab 110, side tabs 150, and computer connector receptacle 160 from a substantially single conductive material and as a unitary structure. This results in a unitary cover structure which provides a substantial ground plane for the printed circuit board 30. Since grounding tab 110 must be flexible to flatten against the printed circuit board 30 and ground the printed circuit board to the memory card holder 10, it is further preferable that the substantially conducting material have sufficient flexible characteristics to allow the grounding tab 110 to be easily flexed and pressed against printed circuit board 30 for grounding. In addition, the material which forms tab 110 is preferably also sufficiently resilient to exert a slight force against the printed circuit board so as to maintain an effective grounding contact. It has been found that stainless steel is a sufficiently flexible, malleable and resilient material to achieve these purposes.

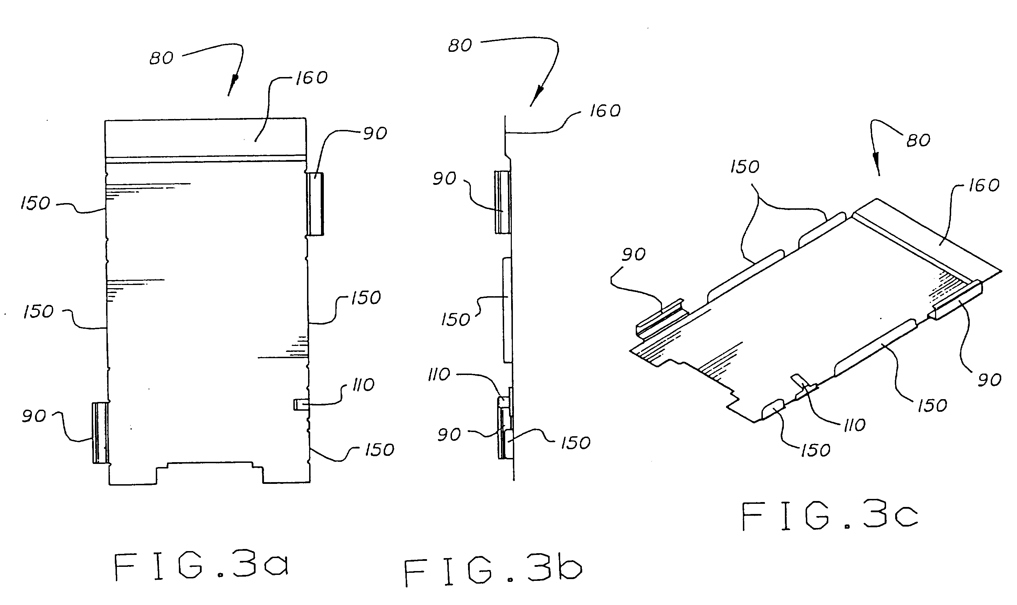

In yet a further preferred embodiment, bottom cover 80 is of a similar unitary construction as that of top cover 70. Thus as shown in Figures 3A, 3B and 3C, bottom cover 80 comprises a unitary stainless steel structure wherein press-fit tabs 90, grounding tab 110, side tabs 150, and computer connector receptacle 160 are integrally formed therefrom. Top cover 70 and bottom cover 80 thus preferably provide two grounding tabs 110 which ensure efficient and reliable grounding of the printed circuit board 30 to the memory card 10.

Referring now to Figure 4, a cross-sectional, end view of the bottom cover illustrates the action of grounding tab 110 when it is pressed against printed circuit board 30. When the printed circuit board 30 is mated in frame 20 (not shown in Figure 4) this combination is then enclosed within the top and bottom covers 70 and 80 respectively. As the frame 20 and printed circuit board 30 mated thereto are brought into close contact with the top and bottom covers, the grounding tabs 110 on the top and bottom covers are flattened against the printed circuit board 30 preferably at an area of the printed circuit board 30 which is adapted to provide circuit grounding. This area usually comprises a grounding contact that is integrally formed on the printed circuit board, or a grounding lead which is otherwise attached to the printed circuit board 30. As shown in the exemplary drawing of Figure 4 illustrating bottom cover 80, grounding tab 110 is pressed towards bottom cover 80 in the direction of the arrow shown after making contact with printed circuit board 30 to provide good grounding contact of the printed circuit board with the stainless steel bottom cover. In this fashion, the printed circuit board 30 is grounded to stainless steel grounding tab 110 and to bottom cover 80 to ensure that printed circuit board 30 is grounded to memory card holder 10.

After printed circuit board 30 is grounded to memory card holder 10 in accordance with the present invention, the entire memory card holder is then preferably chassis grounded to the computer or other electronic equipment in which it is mated. Chassis grounding of the memory card to the computer is accomplished through the unitary frame 20 and spring contacts 120 as described above.

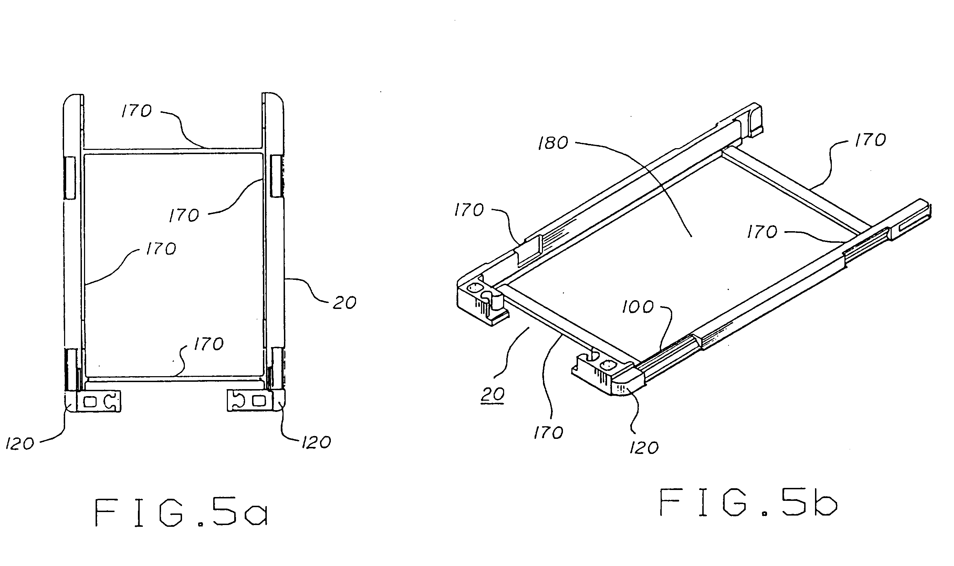

Referring to Figures 5A and 5B, the frame 20 and spring contacts 120 are better illustrated. Frame 20 preferably comprises a plurality of support members shown generally at 170. Two of the support members are parallel lateral support members which are joined at substantially right angles to longitudinal support members form an opening 180 in which the printed circuit board 30 sits. In a further preferred embodiment, the spring contacts 120 are attached to two of the support members 170 which form the longitudinal portions of frame 20. The spring contacts 120 run substantially the entire length of these two support members 170 and are adapted to interface in a socket of the computer in which memory card holder 10 will be mated. When the memory card holder is placed in the socket, the spring contacts aid in sliding the memory card holder through the socket and to mate the memory card holder 10 to a chassis grounding plane that is found in the socket of the computer. This arrangement provides a hard chassis ground for the memory card holder 10 to the computer.

Thus, the printed circuit board 30 is grounded to the unitary frame 20 and top and bottom covers 70 and 80 which are further grounded through spring contacts 120 to the chassis ground in the computer. This arrangement provides effective grounding of the printed circuit board 30 to the memory card holder 10 in the computer so that clear electrical signal characteristics are maintained as data is communicated through the memory card holder.

Apparatus for grounding printed circuit boards to memory card holder provided in accordance with the present invention ensure that the memory card holders operate with superior electrical signal integrity and accurate data communications. Furthermore, the grounding tabs are easily implementable in existing memory card construction so that it is not necessary to utilize complex hardware or circuitry in the memory cards to achieve sufficient chassis grounding of the printed circuit boards found therein. Memory cards provided in accordance with the present invention are thus economical to manufacture and easy to maintain. Such results have not heretofore been achieved in the art and provide significant advantages over prior memory cards which are not adequately grounded.

An important aspect of the present invention resides in the configuration of connector means 40 and frame 20. In particular, connector means 40 comprises mating means 60 for mechanically interfacing with mating means 50 on frame 20 such that the connector means provides structural integrity to the memory card when it is mated to the frame, as described more fully hereinafter.

As described herein before, many prior memory cards lack sufficient structural integrity to allow reliable use in multiple computer devices. Prior memory cards have also been found to be unreliable in applications in which it is desired or required for the card to be inserted and reinserted into a computer or other electronic component with regularity. In accordance with preferred aspects of the present invention, connector means 40 and frame 20 interact to provide added stability, strength and ruggedness to the memory card holder 10. This benefit is achieved, in large part, by the provision of cooperative mating means 50 and 60 on frame 20 and connector means 40, respectively. The cooperative mating means of the present invention preferably provide one or more mating surfaces, such as shoulders, ledges, bumps, ridges and the like, which together substantially restrict relative lateral and longitudinal motion between the connector means and the frame. In this way, connector 40 is mechanically locked into frame 20, thereby imparting added structural rigidity and integrity to the structure. According to preferred embodiments, therefore, connector mating means 60 and frame mating means 50 together comprise locking means for locking and mounting the connector means 40 to frame 20.

According to preferred embodiments of the type illustrated in the figures, connector mating means 60 comprises at least one interlocking tab, and frame mating means 50 comprises at least one receiving means adapted to receive the interlocking tab. With particular reference now to Figures 1, 6A, 6B, and 8, interlocking tab 60 preferably comprises first and second "jigsaw" tabs formed on each lateral side of connector means 40. The jigsaw tabs are preferably fabricated from the same material as a housing 190 which further comprises input/output connector 40. The interlocking means 60 are called "jigsaw tabs" since they preferably resemble interlocking elements of the type found in common jigsaw puzzle pieces. Frame mating means 50 preferably comprises receiving means for securely and snugly receiving interlocking means 60. As shown in the figures, receiving means 50 preferably comprises first and second jigsaw receptacles or pockets having a shape corresponding to jigsaw tabs 60. The jigsaw tabs 60 are preferably formed to be just slightly larger than means 50 so as to produce a snug interference fit according to manufacturing techniques known in the art.

It will be appreciated by those skilled in the art that numerous variations and modifications of the mating means illustrated in the figures are possible within the scope of the present invention. For example, it is contemplated that the connector mating means may comprise a receiving means, in which case the frame will carry a corresponding interlocking tab. Furthermore, it is contemplated that it may be desirable in certain embodiments for the connector mating means to comprise at least one interlocking tab and at least one receiving means. In such embodiments, the frame mating means comprises its own receiving means for accepting the connector jigsaw tab and its own jigsaw tab for interlocking with the receiving means on the connector. In view of the disclosure contained herein, numerous other variations will be apparent to those skilled in the art.

It will also be appreciated by those skilled in the art that the interlocking tab and the corresponding receiving means of the present invention may provide interfacing surfaces in numerous shapes and sizes. For example, it is contemplated that the bulbous jigsaw tab 60 shown in the figures may be replaced or supplemented by an interlocking tab in the form of a star shaped projection. Interlocking tabs in the form of other shapes, both regular and irregular, are possible within the scope of the present invention. In general, it is only required that the interlocking tabs and the receiving means therefor provide one or more mating surfaces which together substantially restrict, and preferably prevent, relative longitudinal and lateral motion between the connector means and the frame.

When mated to frame 20, connector 40 provides structural integrity to memory card holder 10 since it imparts significant rigid structure to the frame. Initially frame 20 is only partially rigid, and when mated to the printed circuit board 30, the frame and printed circuit board form the partial memory card holder. By mechanically interfacing the connector means 40 to the partial memory card holder, the locking of jigsaw tabs 60 to the corresponding jigsaw receptacles 50 provides further rigidity to frame 20. As a result, memory card holder 10 is provided with substantial structural integrity as compared to prior memory cards having frames which do not comprise the connectors described herein.

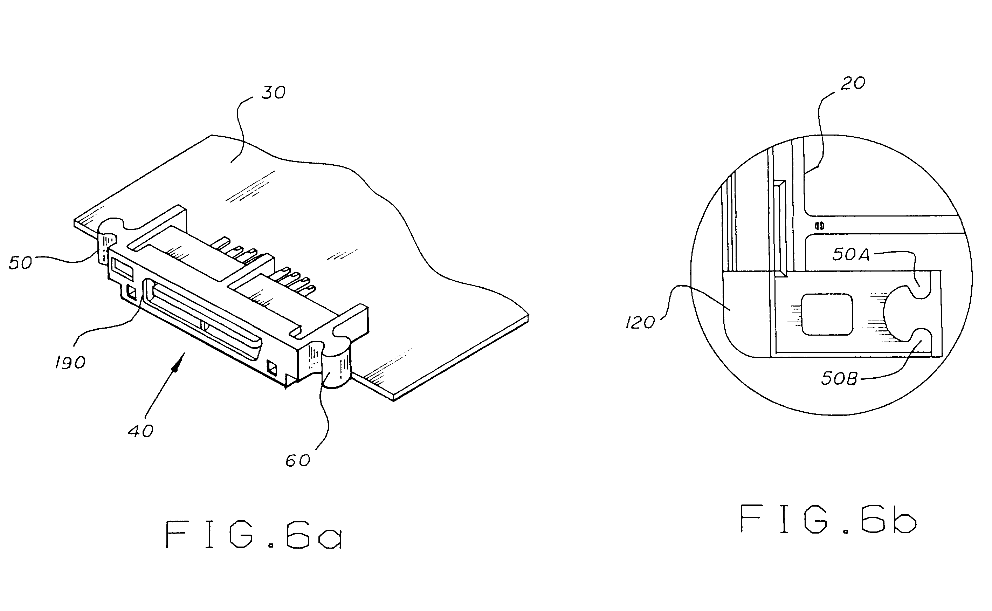

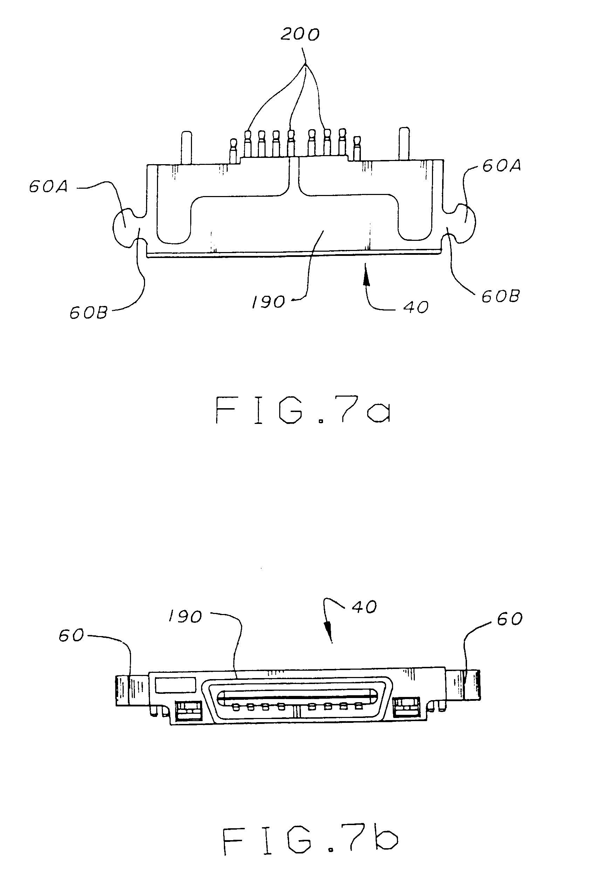

Referring to Figures 7A and 7B, plan and elevational views, respectively, of preferred connector means 40 are illustrated. The connector 40 comprises housing 190 and first and second jigsaw tabs 60 projecting from lateral or side portions of the housing. The jigsaw tabs preferably comprise a bulbous portion 60A attached to housing 190 by stem portion 60B. The area of connection between stem 60B and bulbous portion 60A form two outer shoulders. Two inner shoulders are formed at the area of connection between the stem 60B and housing 190. As shown in Figure 6B, receiving means 50 comprises a socket formed, in part, by ledges 50A and 50B which mechanically interface with the shoulder portions described above. This mechanical interface between the shoulder portions of the connector means 40 and ledges 50A and 50B is largely responsible for substantially restricting lateral and longitudinal movement between the connector and the frame. The other mating surfaces of the tab 60 and the socket 50 likewise contribute to restricting relative movement between the connector means 40 and frame 20.

Housing 190 preferably comprises a glass-filled polycarbonate material which can be injection molded by known injection molding techniques such that jigsaw tabs 60 are integral parts of housing 190 on lateral or side portions of the housing. Jigsaw tabs 60 which will interface and mate with the jigsaw receptacles 50 on frame 20 therefore also preferably comprise a glass-filled polycarbonate material and are integrally formed with the housing 190 during the molding process.

In a further preferred embodiment, input/output connector 40 further comprises a plurality of terminals, shown generally at 200, adapted to be surface mounted to the printed circuit board 30 in input/output memory card holder 10. In still further preferred embodiments, terminals 200 are 0.25 centimeters thick and are plated with 1.27 micrometers of phosphor bronze plating to make good surface and electrical contact with printed circuit board 30.

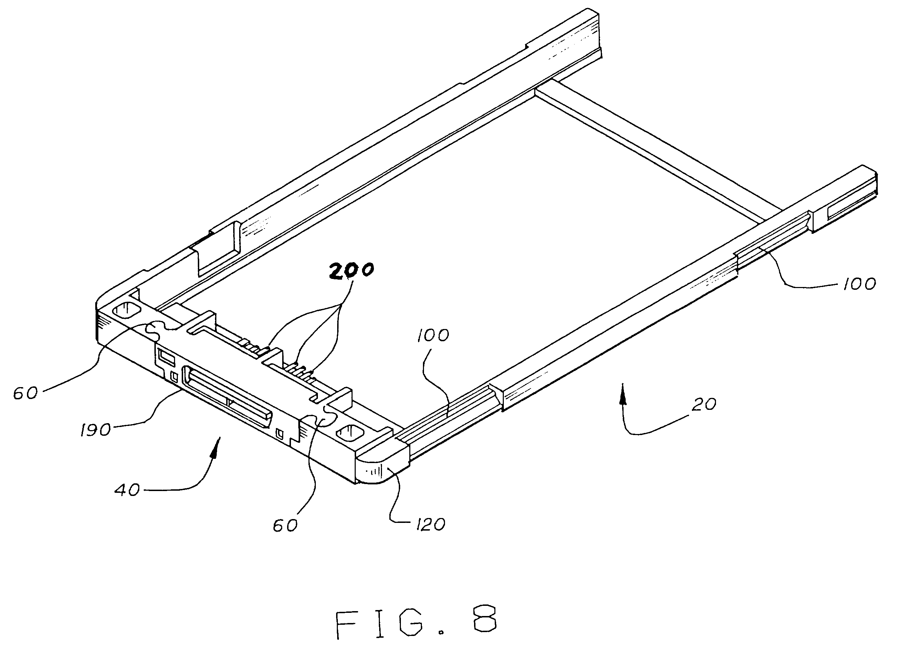

Referring to Figure 8, an isometric, plan view illustrating the mating of a jigsaw tab 60 with a jigsaw retaining receptacle 50 is illustrated. By securely mating jigsaw tab 60 in jigsaw receptacle 50, significant structural integrity is achieved for frame 20. It is believed that frame 20 having jigsaw receptacles mated with jigsaw tabs in accordance with the present invention will achieve at least about 50% more rigidity than prior frames which lack the connector means described in accordance with the present invention. This evinces a significant improvement in the total structural integrity of memory card holder 10 and greatly facilitates the use and interchangeability of memory cards provided in accordance with the present invention with computer. Thus, the memory card holders and connectors of the present invention provide improved durability, and greatly reduce the costs of providing external memories to computer equipment, and facilitate the efficiency of installations using these devices.

There have thus been described certain preferred embodiments of memory cards and connectors provided in accordance with the present invention. While preferred embodiments have been described and disclosed, it will be recognized by those with skill in the art that modifications are within the true scope of the invention. The appended claims are intended to cover all such modifications.

## Claims

1. A memory card holder (10) including an electrical connector (40) and a frame (20) for receiving a memory card (30) containing electrical circuit traces and ground traces thereon, said frame (20) including a pair of side rails, and a pair of hermaphroditic, electrically conductive cover members (70,80) adapted to engage said side rails, characterized in that:
each said cover member (70,80) includes an integral angularly disposed, inwardly directed grounding tab (110) for compressive contact with a complementary ground trace on said memory card (30), and plural peripheral tabs (90,150) in contact with and in sealing engagement with said frame side rails;
and wherein interlocking members (50,60) are provided on the connector (40) and the frame (20) for joining the connector (40) to the frame (20) and the memory card (30).

2. The memory card holder (10) according to claim 1, wherein the frame (20) includes plural transverse members extending between said frame side rails.

3. The memory card holder (10) according to claims 1 or 2, wherein contacts (120) are attached to the two side rails for grounding the memory card (30) in an electronic device when the memory card (30) is mated to the electronic device.

4. The memory card holder (10) according to any of claims 1-3, wherein certain of said tabs (90,150) are press-fit tabs (90) attached to the sides of the cover (70,80) and protruding therefrom for mating with a plurality of reciprocal press-fit openings (100) on said side rails to tightly seal the cover (70,80) to the frame (20).

5. The memory card holder (10) according to any of claims 1-4, further including a receptacle (160) on one end of said covers (70,80) for housing a connector (130) for mating the memory card (30) to an electronic component.

6. The memory card holder (10) according to any preceding claim, wherein the interlocking members comprise a jigsaw-shaped tab (60) for disposition between a pair of ledges (50A,50B).

## Patentansprüche

1. Speicherkartenhalter (10), der umfaßt: einen elektrischen Verbinder (40), und einen Rahmen (20) für das Aufnehmen einer Speicherkarte (30), die die elektrischen Leiterbahnen und Erdungsleiterbahnen darauf enthält, wobei der Rahmen (20) umfaßt: ein Paar Seitenschienen, und ein Paar zwitterartige elektrisch leitende Abdeckelemente (70, 80), die so konstruiert sind, daß sie mit den Seitenschienen in Eingriff kommen, dadurch gekennzeichnet, daß:
jedes Abdeckelement (70, 80) umfaßt: eine integrierte winkelig angeordnete, nach innen gerichtete Erdungsnase (110) für einen Druckkontakt mit einer komplementären Erdungsleiterbahn auf der Speicherkarte (30), und mehrere periphere Nasen (90, 150) in Kontakt und in abdichtendem Eingriff mit den Seitenschienen des Rahmens;
und worin die Verriegelungselemente (50, 60) am Verbinder (40) und dem Rahmen (20) für ein Verbinden des Verbinders (40) mit dem Rahmen (20) und der Speicherkarte (30) vorhanden sind.

2. Speicherkartenhalter (10) nach Anspruch 1, bei dem der Rahmen (20) mehrere Querelemente umfaßt, die sich zwischen den Seitenschienen des Rahmens erstrecken.

3. Speicherkartenhalter (10) nach Anspruch 1 oder 2, bei dem die Kontakte (120) an den zwei Seitenschienen für das Erden der Speicherkarte (30) in einer elektronischen Vorrichtung befestigt sind, wenn die Speicherkarte (30) mit der elektronischen Vorrichtung in Eingriff kommt.

4. Speicherkartenhalter (10) nach einem der Ansprüche 1 bis 3, bei dem bestimmte Nasen (90, 150) Preßpassungsnasen (90) sind, die an den Seiten der Abdeckung (70, 80) befestigt sind und daraus hervorstehen, um mit einer Vielzahl von wechselseitigen Preßpassungsöffnungen (100) an den Seitenschienen in Eingriff zu kommen, um die Abdeckung (70, 80) am Rahmen (20) dicht zu verschließen.

5. Speicherkartenhalter (10) nach einem der Ansprüche 1 bis 4, der außerdem eine Steckbuchse (160) an einem Ende der Abdeckungen (70, 80) für das Aufnehmen eines Verbinders (130) für einen Eingriff der Speicherkarte (30) in ein elektronisches Bauteil umfaßt.

6. Speicherkartenhalter (10) nach einem der vorhergehenden Ansprüche, bei dem die Verriegelungselemente eine puzzleförmige Nase (60) für eine Anordnung zwischen einem Paar Absätzen (50A, 50B) aufweisen.

## Revendications

1. Support de carte de mémoire (10) englobant un connecteur électrique (40) et un cadre (20) pour recevoir une carte de mémoire (30) contenant des lignes de circuit électriques et des lignes de masse, ledit cadre (20) englobant une paire de rails latéraux et une paire d'éléments de couvercle hermaphrodites, électroconducteurs (70, 80), destinés à s'engager dans lesdits rails latéraux, caractérisé en ce que:
chacun desdits éléments de couvercle (70, 80) englobe une patte de mise à la masse intégrante (110), à agencement angulaire, dirigée vers l'intérieur, pour établir un contact par compression avec une ligne de masse complémentaire sur ladite carte de mémoire (30), et plusieurs pattes périphériques (90, 150) en contact avec lesdits rails latéraux du cadre et engagées de façon étanche dans celui-ci;
des éléments d'interverrouillage (50, 60) sont agencés sur le connecteur (40) et le cadre (20) pour relier le connecteur (40) au cadre (20) et à la carte de mémoire (30).

2. Support de carte de mémoire (10) selon la revendication 1, dans lequel le cadre (20) englobe plusieurs éléments transversaux s'étendant entre lesdits rails latéraux du cadre.

3. Support de carte de mémoire (10) selon les revendications 1 ou 2, dans lequel les contacts (120) sont fixés aux deux rails latéraux pour mettre à la masse la carte de mémoire (30) dans un dispositif électronique lors de l'accouplement de la carte de mémoire (30) au dispositif électronique.

4. Support de carte de mémoire (10) selon l'une quelconque des revendications 1 à 3, dans lequel certaines desdites pattes (90, 150) sont des pattes ajustées par pression (90), fixées aux côtés du couvercle (70, 80) et débordant de celui-ci, en vue de l'accouplement avec plusieurs ouvertures à ajustement par pression réciproques (100) sur lesdits rails latéraux, pour sceller fermement le couvercle (70, 80) au cadre (20).

5. Support de carte de mémoire (10) selon l'une quelconque des revendications 1 à 4, englobant en outre un réceptacle (160) sur une extrémité desdits couvercles (70, 80) pour accueillir un connecteur (130) en vue de l'accouplement de la carte de mémoire (30) à un composant électronique.

6. Support de carte de mémoire (10) selon l'une quelconque des revendications précédentes, dans lequel les éléments d'interverrouillage comprennent une patte en puzzle (60) destinée à être agencée entre une paire de moulures (50A, 50B).
